# DEMANDE DE BREVET EUROPEEN

(11) **EP 2 348 527 A1**
(43) Date de publication de la demande: **27.07.2011**
(21) Numéro de dépôt: 10192672.3
(22) Date de dépôt: 26.11.2010
(51) Int. Cl.: H01L 21/762, H01L 21/18, H01L 21/20

(54) **Procédé de recuit d'une structure**

(30) Priorité: 25.01.2010 FR 1050469
(71) Demandeur: S.O.I. Tec Silicon on Insulator Technologies, 38190 Bernin (FR)
(72) Inventeur: Sousbie, Nicolas, 38000, GRENOBLE (FR); Aspar, Bernard, 38330, SAINT ISMIER (FR); Barge, Thierry, 38160, CHEVRIERES (FR); Lagahe Blanchard, Chrystelle, 38920, CROLLES (FR)
(74) Mandataire: Desormiere, Pierre-Louis

(57) **Abrégé**

L'invention concerne un procédé de recuit d'une structure comprenant au moins une plaque, le procédé de recuit comprenant une première étape de recuit de la structure sous atmosphère oxydante de manière à former une couche d'oxyde (310) sur au moins une partie de sa surface exposée, la structure étant en contact avec un support (312) dans une première position. Le procédé comprend en outre une étape de déplacement de la structure sur le support dans une seconde position dans laquelle la ou les zones de contact (314) entre la structure et le support lors de la première étape de recuit sont exposées et une deuxième étape de recuit de la structure dans la deuxième position sous atmosphère oxydante.

## Description

La présente invention se rapporte au domaine des recuits sous atmosphère oxydante utilisés notamment lors de la réalisation de structures ou substrats semi-conducteurs multicouches (également dénommées "multilayer semiconductor wafers") obtenues par transfert d'au moins une couche sur un support tels que les structures de type BSOI (« Bonded Silicon On Insulator » en anglais).

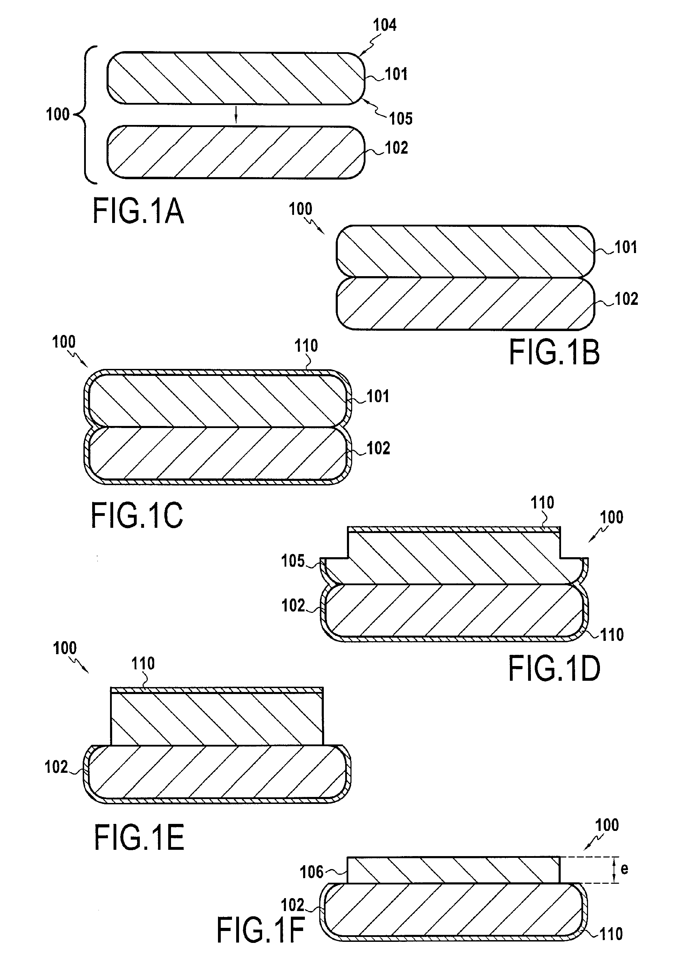

Un exemple de procédé de fabrication connu d'une structure multicouche est décrit en référence aux figures 1A à 1F.

Comme représentée en figures 1A et 1B, une structure composite 100 est formée par assemblage d'une première plaque 101 avec une deuxième plaque 102, par exemple en silicium. Les première et deuxième plaques 101 et 102 présentent ici le même diamètre. Elles pourraient toutefois avoir des diamètres différents.

Une couche supplémentaire (non représentée) de type couche d'oxyde peut être formée sur une ou les deux plaques 101 et 102 avant la mise en contact de celles-ci, dans le cas notamment de la fabrication d'une structure de type SOI (en anglais « *Silicon on Insulator»).*

La première plaque 101 présente un bord chanfreiné, à savoir un bord comprenant un chanfrein supérieur 104 et un chanfrein inférieur 105.

Le rôle de ces chanfreins est de faciliter la manipulation des plaques et d'éviter les bris de bords qui pourraient se produire si ces bords étaient saillants, de tels bris étant sources de contamination en particules des surfaces des plaques.

Dans l'exemple décrit ici, l'assemblage des plaques est réalisé par la technique d'adhésion moléculaire bien connue de l'homme du métier.

Une fois l'étape de collage réalisée, la structure composite 100 subit un recuit de stabilisation qui a pour but de renforcer le collage entre la première plaque 101 et la deuxième plaque 102 et de recouvrir ces dernières d'une couche d'oxyde protectrice.

A cet effet, on effectue le recuit de stabilisation sous atmosphère oxydante de manière à former une couche d'oxyde 110 sur toute la surface exposée de la structure composite 100 (figure 1C). La couche d'oxyde 100 forme ainsi une couche de protection qui permet de protéger la structure composite des attaques chimiques, notamment lors de l'opération de traitement ultérieure.

On procède ensuite au détourage de la structure 100 qui consiste à éliminer principalement une portion annulaire de la couche 106 comprenant le chanfrein 105 (figures 1D et 1E).

La réalisation d'un tel détourage est nécessaire car la présence du chanfrein 105 empêche un bon contact entre la première et la deuxième plaque au niveau de leur périphérie. Il existe donc une zone périphérique sur laquelle la couche transférée est peu ou pas collée sur la deuxième plaque. Cette zone périphérique de la couche transférée doit être éliminée car elle est susceptible de se casser de façon non contrôlée et de contaminer la structure par des fragments ou particules indésirables.

On procède de préférence à un détourage dit mixte qui consiste à réaliser une première étape de détourage par action ou usinage entièrement mécanique (figure 1D), suivie d'une deuxième étape de détourage au moins partiellement non mécanique sur l'épaisseur restante de la première plaque (figure 1E). Cette deuxième étape de détourage correspond en général à un détourage chimique sélectif vis à vis des couches d'oxydes formées sur les plaques 101 et/ou 102. Le détourage mixte permet notamment d'éviter les problèmes d'écaillage aussi bien au niveau de l'interface de collage entre la couche transférée et la deuxième plaque que dans la couche transférée elle-même.

Dans l'exemple envisagé ici, l'étape de détourage chimique consiste à réaliser une gravure chimique, encore appelée gravure humide. La solution de gravure chimique est choisie en fonction du matériau à attaquer. Dans cet exemple, on utilise la solution de gravure TMAH ou de KOH bien connue de l'homme du métier, cette solution permettant en particulier la gravure du silicium.

La première plaque 101 peut ensuite être amincie afin de former une couche transférée 106 d'une épaisseur e déterminée (figure 1F). Cette épaisseur e peut atteindre par exemple 10 µm environ.

L'oxydation de la structure composite 100 (figure 1C) avant l'opération de détourage permet d'empêcher la deuxième plaque 102 d'être gravée chimiquement par la solution TMAH lors de l'étape de détourage chimique. La couche d'oxyde 110 permet également de protéger la surface de la première plaque 101 de l'attaque chimique de détourage, avant son amincissement.

La déposante a cependant observé l'apparition de défauts au niveau des bords des structures composites obtenues après l'étape de détourage chimique.

Plus spécifiquement, les défauts observés se présentent sous la forme d'égratignures réparties sur les bords (ou la tranche) de la deuxième plaque des structures composites.

Ces égratignures sont indésirables pour le fabricant puisqu'elles peuvent, par exemple, être la source de bris provenant de la deuxième plaque, ces bris étant susceptibles de contaminer la surface exposée de la première plaque. De manière plus générale, ces défauts témoignent d'un procédé de fabrication non optimisé, ce qui diminue l'attractivité des structures multicouches ainsi produites. Ces défauts peuvent par ailleurs engendrer divers problèmes lors de la réalisation d'étapes technologiques complémentaires sur ces structures composites défectueuses (par exemple, lors de la fabrication de microcomposants sur la surface exposée de la première plaque).

Or, il existe un besoin pour réaliser des structures composites sans de tels défauts, et ce même lorsque le procédé de fabrication de ces structures comprend une ou plusieurs étapes mettant en oeuvre des attaques chimiques. De telles attaques chimiques peuvent intervenir notamment, mais de manière non exhaustive, lors d'une opération de détourage ou d'une étape d'amincissement de la première plaque.

### Objet et résumé de l'invention

A cet effet, l'invention propose un procédé de recuit d'une structure comprenant au moins une plaque, le procédé de recuit comprenant une première étape de recuit de la structure sous atmosphère oxydante de manière à former une couche d'oxyde sur au moins une partie de la surface exposée de la structure, la structure étant en contact avec un support dans une première position, caractérisé en ce que le procédé comprend en outre :
- une étape de déplacement de la structure oxydée sur le support dans une seconde position dans laquelle la ou les zones de contact entre la structure et le support dans la première position sont exposées ; et
- une deuxième étape de recuit de la structure dans la deuxième position sous atmosphère oxydante.

Le procédé de recuit de l'invention s'applique en particulier aux structures multicouches. Comme indiqué précédemment, on entend par structure multicouche, une structure réalisée par transfert d'au moins une première plaque sur une deuxième plaque (ou support), tel que par exemple les structures de type BSOI.

Le procédé de recuit de l'invention s'applique également à une plaque unique, celle-ci pouvant par la suite être assemblée à une ou plusieurs autres plaques.

Le procédé selon l'invention permet de faire croître une couche d'oxyde sur la ou les zones de la structure qui étaient en contact avec le support lors de la première étape de recuit. Ceci est possible car les zones de la structure qui étaient en contact avec le support lors de la première étape de recuit sont découvertes (i.e. ne sont plus en contact avec le support) une fois la structure disposée dans la deuxième position. De cette manière, on forme une couche d'oxyde uniforme sur toute la surface exposée du ou des substrats soumis au procédé de recuit selon l'invention.

Cette couche d'oxyde permet de protéger la structure des attaques chimiques ultérieures pouvant être réalisées sur la structure.

Par exemple, cette couche d'oxyde protège efficacement la structure des attaques chimiques pouvant être mises en oeuvre lors d'une opération d'amincissement ou de détourage sur toute ou partie de la structure.

La couche d'oxyde ainsi formée permet également de protéger la structure des attaques chimiques mises en oeuvre lors d'une opération de traitement chimique sur toute ou partie de la structure.

Ainsi, le procédé de recuit permet d'empêcher la formation d'égratignures sur la structure, et notamment sur ses bords, lors d'une attaque chimique.

Le support peut correspondre, par exemple, à une pluralité d'éléments de maintien permettant de maintenir la structure en position.

Dans un mode de réalisation particulier, aucun traitement n'est réalisé sur la structure entre la première étape de recuit et la deuxième étape de recuit. On entend dans ce document par « traitement », une étape technologique quelconque visant à modifier les caractéristiques de ladite structure. Une telle étape technologique peut faire intervenir, par exemple, une gravure chimique, un dépôt de matériaux, un dopage...

Dans cette variante, l'étape de déplacement est la seule opération réalisée sur la structure entre la première étape de recuit et la deuxième étape de recuit. Ce mode de réalisation permet notamment de s'assurer du bon positionnement de la structure lors de la deuxième étape de recuit.

Par ailleurs, l'étape de déplacement peut comprendre la rotation de la structure d'un angle déterminé par rapport au support de manière à ce que toutes les zones de la structure en contact avec le support pendant la première étape de recuit ne soient plus en contact avec le support à l'issue de l'étape de déplacement.

De cette manière, il est possible de faire croître une couche d'oxyde sur toutes les zones de la structure qui étaient en contact avec le support lors de la première étape de recuit. Cette couche d'oxyde est avantageuse en ce qu'elle protège toute la structure des attaques chimiques pouvant être mises en oeuvre ultérieurement. Il est ainsi possible d'éviter la formation d'égratignures sur la surface de la structure lorsqu'une attaque chimique est par la suite mise en oeuvre.

L'angle de rotation de la structure lors de l'étape de déplacement peut être compris, par exemple, entre 40 et 90 degrés.

L'invention concerne également un premier procédé de réalisation d'une hétérostructure comprenant une étape de collage d'une première plaque sur une deuxième plaque, caractérisé en ce que le procédé comprend en outre le recuit de l'hétérostructure selon le procédé de recuit défini dans l'un des modes de réalisation mentionnés ci-dessus.

Le premier procédé de réalisation d'une hétérostructure permet de réaliser une hétérostructure comprenant une première et une deuxième plaque, et ce tout en évitant la formation d'égratignures sur la deuxième plaque lors de l'étape de détourage chimique.

En particulier, ce procédé permet d'éviter la formation d'égratignures au niveau des bords de la deuxième plaque.

Le recuit réalisé sur l'hétérostructure est de préférence réalisé de manière à ce que toutes les zones de la deuxième plaque en contact avec le support pendant la première étape de recuit ne soient plus en contact avec le support à l'issue de l'étape de déplacement. De cette manière, une couche d'oxyde protectrice est formée sur toute la surface extérieure de la deuxième plaque, cette couche d'oxyde permettant de protéger la deuxième plaque des attaques chimiques pouvant être mises en oeuvre ultérieurement.

Par ailleurs, au moins une des étapes suivantes peut être réalisée après le recuit de l'hétérostructure:
- une étape d'amincissement de la première plaque, et
- une étape de détourage chimique de la première plaque.

On entend ici par détourage chimique, une opération de détourage mettant en oeuvre au moins une attaque chimique

L'invention concerne en outre un deuxième procédé de réalisation d'une hétérostructure comprenant une étape de collage d'une première plaque sur une deuxième plaque, caractérisé en ce que le procédé comprend en outre, avant l'étape de collage, le recuit de la deuxième plaque selon le procédé de recuit défini dans l'un des modes de réalisation mentionnés ci-dessus.

Ce procédé de réalisation d'une hétérostructure permet de former une couche d'oxyde sur la surface de la deuxième plaque, cette couche offrant une protection efficace à la deuxième plaque vis-à-vis des attaques chimiques.

Le deuxième procédé peut comprendre en outre, avant l'étape de collage, une étape de formation d'au moins un microcomposant dans la première plaque.

Ce procédé est avantageux en ce que la première plaque ne subit pas les première et deuxième étapes de recuit. De cette manière, les composants formés au préalable dans la première plaque ne sont pas endommagés lors des première et deuxième étapes de recuit.

Le deuxième procédé de réalisation d'une hétérostructure peut comprendre en outre une étape de recuit de stabilisation ou de renforcement de l'interface de collage de l'hétérostructure.

Cette étape de recuit de stabilisation ou de renforcement de l'interface de collage permet de renforcer le collage entre la première plaque et la deuxième plaque.

Par ailleurs, au moins une des étapes suivantes peut être réalisée après ce recuit de stabilisation ou de renforcement de l'interface de collage:
- une étape d'amincissement de la première plaque ; et
- une étape de détourage chimique de la première plaque.

La couche d'oxyde formée sur la deuxième plaque sert ainsi de protection vis-à-vis des attaques chimiques mises en oeuvre notamment lors des étapes ultérieures d'amincissement et/ou de détourage chimique.

### Brève description des dessins

D'autres caractéristiques et avantages de la présente invention ressortiront de la description faite ci-dessous, en référence aux dessins annexés qui en illustrent un exemple de réalisation. Sur les figures :
- les figures 1A à 1F sont des vues schématiques d'un procédé de recuit de stabilisation connu de l'art antérieur ;
- les figures 2A à 2C illustre de manière schématique le mécanisme de formation d'égratignures sur les bords d'une hétérostructure au cours de son procédé de fabrication ;
- les figures 3A à 3D représentent de manière schématique un premier procédé de réalisation d'une hétérostructure selon l'invention ;
- la figure 4 représente, sous forme d'un organigramme, les étapes du premier procédé de réalisation d'une hétérostructure illustré aux figures 3A à 3D ;
- les figures 5A à 5E représentent de manière schématique un deuxième procédé de réalisation d'une hétérostructure selon l'invention ; et
- la figure 6 représente, sous forme d'un organigramme, les étapes du deuxième procédé de réalisation d'une hétérostructure illustré aux figures 5A à 5C.

### Description détaillée d'un mode de réalisation

La présente invention s'applique, d'une manière générale, à la réalisation d'un recuit en plusieurs étapes sur une structure comprenant au moins une plaque.

La ou les plaques composant la structure se présentent généralement sous la forme de tranches ou "wafers" au contour généralement circulaire et peuvent présenter différents diamètres, notamment des diamètres de 100 mm, 200 mm ou 300 mm. Toutefois, il peut également s'agir de plaques de forme quelconque, comme une plaque de forme rectangulaire, par exemple.

On réalise une structure composite, ou hétérostructure, en collant une première plaque sur une deuxième plaque constituant le support de la première plaque.

Comme indiqué précédemment, la déposante a constaté l'apparition d'égratignures sur les bords des structures composites ayant subi une attaque chimique telle que lors d'un détourage ou d'un amincissement mettant en oeuvre une phase chimique, et ce alors que la structure a été préalablement soumise à un recuit de stabilisation standard sous atmosphère oxydante. Ces égratignures ont notamment été observées sur les bords de la deuxième plaque des structures composites.

Une étude approfondie de ces égratignures a permis de mettre en évidence le mécanisme de formation de ces défauts et d'élaborer un procédé permettant d'empêcher leur formation.

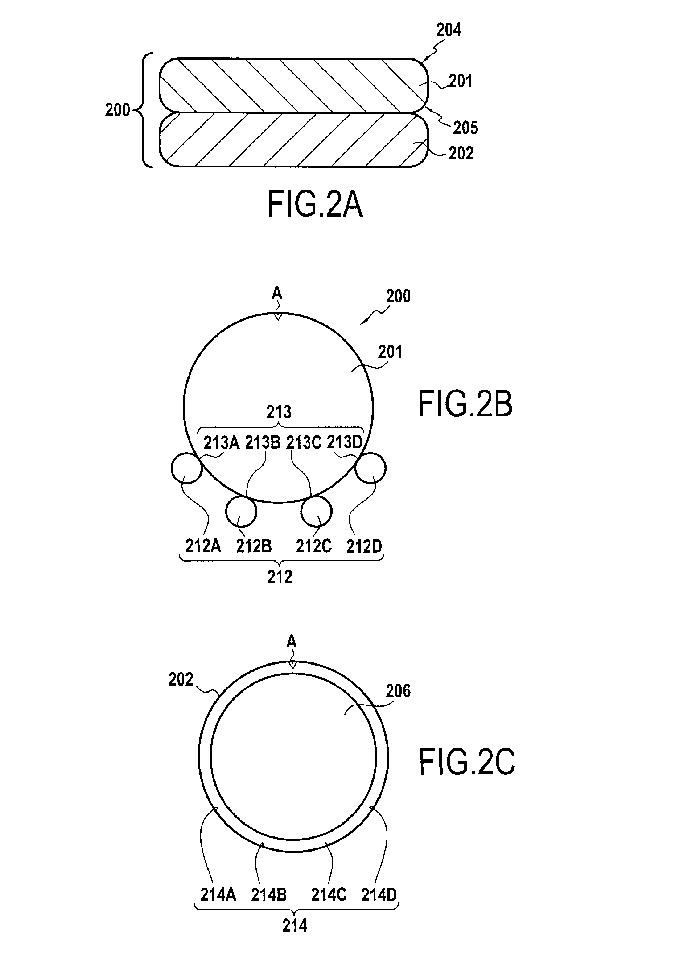

Le mécanisme à l'origine de ces défauts est à présent décrit en référence aux figures 2A à 2C.

On considère, en relation avec la figure 2A, un exemple de structure composite similaire à celle décrite en figure 1B, à savoir une structure composite 200 formée par assemblage d'une première plaque 201 sur une deuxième plaque 202.

De préférence, au moins l'une des deux plaques 201 et 202 a été oxydée avant collage. Cette oxydation permet en particulier d'avoir une couche d'oxyde intercalée entre les deux plaques une fois le collage réalisé. Dans l'exemple décrit ici, la première plaque 201 est oxydée avant collage, de manière à former une couche d'oxyde (non représentée sur les figures) sur toute la surface de la première plaque.

Dans l'exemple décrit ici, les deux plaques sont en silicium et l'assemblage des plaques est réalisé par la technique d'adhésion moléculaire bien connue de l'homme du métier. D'autres techniques de collage peuvent toutefois être utilisées, comme par exemple le collage anodique, métallique, ou avec adhésif.

Pour rappel, le principe du collage par adhésion moléculaire est basé sur la mise en contact direct de deux surfaces, c'est-à-dire sans l'utilisation d'un matériau spécifique (colle, cire, brasure, etc.). Une telle opération nécessite que les surfaces à coller soient suffisamment lisses, exemptes de particules ou de contamination, et qu'elles soient suffisamment rapprochées pour permettre d'initier un contact, typiquement à une distance inférieure à quelques nanomètres. Dans ce cas, les forces attractives entre les deux surfaces sont assez élevées pour provoquer l'adhérence moléculaire (collage induit par l'ensemble des forces attractives (forces de Van Der Waals) d'interaction électronique entre atomes ou molécules des deux surfaces à coller).

Par ailleurs, la première plaque 201 présente un bord chanfreiné, à savoir un bord comprenant un chanfrein supérieur 204 et un chanfrein inférieur 205. Sur la figure 2A, les plaques présentent des chanfreins de forme arrondie. Toutefois, les plaques peuvent présenter des chanfreins ou tombées de bord de différentes formes telles qu'une forme en biseau.

La figure 2B représente de manière schématique la structure composite 200, vue du côté de la première plaque 201. Le repère de position « A » représenté au bord de la première plaque 201 correspond, par exemple, à un méplat ou à une mire.

La structure composite 200 est disposée sur un support 212 (appelé parfois nacelle) afin de procéder à un recuit standard sous atmosphère oxydante. Il s'agit ici d'un recuit de stabilisation qui a pour but de renforcer le collage entre la première plaque 201 et la deuxième plaque 202 et de former une couche d'oxyde de protection.

Dans cet exemple, le support 212 comprend quatre éléments de maintien 212A, 212B, 212C et 212D configurés pour maintenir la structure composite 200 en position. Les éléments de maintien sont en contact avec les bords (ou la tranche) de la structure composite 200, et plus particulièrement, en contact avec les bords (ou la tranche) de la deuxième plaque 202. Les portions de la tranche de la deuxième plaque 202 en contact avec les éléments de maintien sont désignées respectivement par les zones de contact 213A, 213B, 213C et 213D (et notées collectivement zones de contact 213).

La structure composite 200 et son support 212 sont placés dans un four ou tout autre équipement adapté pour réaliser un recuit (non représenté sur les figures). On réalise un recuit de stabilisation sur la structure composite 200 à une température T1 comprise, par exemple, entre 900°C et 1200°C, typiquement à 1100°C pendant deux heures.

Le recuit permet de former une couche d'oxyde sur la surface exposée de la première plaque 201 et de la deuxième plaque 202.

On réalise ensuite une étape de détourage mixte de la première plaque 201, comme décrit en référence aux figures 1D et 1E. Dans l'exemple décrit ici, le détourage mixte comprend une première étape de détourage partiel mécanique à l'aide d'une meule ou d'une lame, suivie d'une étape de gravure chimique sélective de la première plaque, à l'aide d'une solution d'attaque TMAH.

Cette opération de détourage permet d'éliminer la partie de la première plaque 201 en excès sur les bords, et ce sans endommager la deuxième plaque 202. La préservation de la deuxième plaque 202 est possible car la couche d'oxyde (non représentée) intercalée entre les deux plaques sert de couche d'arrêt lors de la gravure chimique. La gravure chimique est ainsi interrompue en périphérie de la première plaque 201 au niveau de la couche d'oxyde située à l'interface de collage entre les deux plaques.

Une fois le détourage réalisé, on peut procéder à l'amincissement de la première plaque 201 de manière à former une couche transférée 206 d'une épaisseur e déterminée, par exemple, de 10 µm environ.

L'amincissement est réalisé à l'aide d'une meule ou tout autre outil apte à user mécaniquement le matériau de la première plaque (« grinding » en anglais).

La figure 2C représente de manière schématique la structure 200 une fois le recuit de stabilisation, le détourage mixte et l'amincissement effectués.

La déposante a constaté l'apparition d'égratignures 214A, 214B, 214C et 214D (notées collectivement 214) au niveau de la tranche de la deuxième plaque 202 après l'attaque chimique au TMAH. La répartition de ces défauts le long de la tranche de la deuxième plaque 202 correspond aux emplacements des zones de contact 213 mentionnées ci-dessus.

En réalité, lors du recuit de stabilisation de la structure composite 200, une couche d'oxyde (de SiO₂, dans le présent exemple) se forme sur l'ensemble de la surface exposée de la structure composite 200, à l'exception des zones de contact 213. En effet, lors du recuit de stabilisation, les éléments de maintien 212A à 212D masquent localement la tranche de la deuxième plaque 202 de sorte que les zones de contact ne sont pas recouvertes par une couche d'oxyde.

A ce phénomène de masquage peut s'ajouter un autre phénomène, à savoir la détérioration de l'oxyde pouvant être présent sur la structure au niveau des points de contact (arrachement, rayure lors du retrait ou autres mouvements de la plaque,...). Les éléments de maintien 212 peuvent en effet endommager localement la couche d'oxyde préliminaire formée sur la première plaque 201 (ou éventuellement sur la deuxième plaque 202) avant collage et/ou la couche d'oxyde se formant dans le voisinage des points de contact 213 lors du recuit de stabilisation.

Les zones de contact 213 de la deuxième plaque 201 étant dépourvues d'une couche d'oxyde protectrice, celles-ci subissent directement l'action de gravure chimique de la solution TMAH lors de l'étape d'amincissement et/ou de détourage chimique. La gravure chimique au niveau des zones de contact 213 génère alors les égratignures 214. Les égratignures 214A, 214B, 214C et 214D ont ainsi été observées sur la deuxième plaque 202 aux emplacements des zones de contact 213A, 213B, 213C et 213D, respectivement. Plus les zones non protégées par de l'oxyde sont grandes et plus l'effet de gravure de la solution TMAH est important.

Ces défauts en surface générés sur la tranche de la deuxième plaque 202 sont préjudiciables pour les raisons déjà évoquées précédemment.

A cet effet, la présente invention propose de réaliser un recuit en plusieurs étapes, avec déplacement de la structure sur le support entre deux étapes de recuit consécutives, de manière à éviter l'apparition de ces égratignures, notamment au niveau de la tranche (ou des bords) de la deuxième plaque.

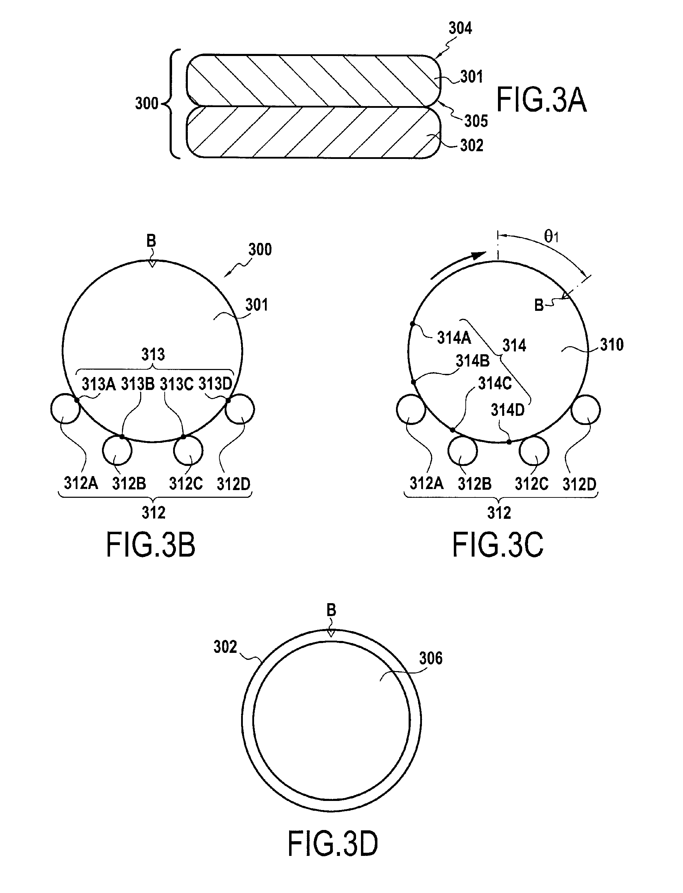

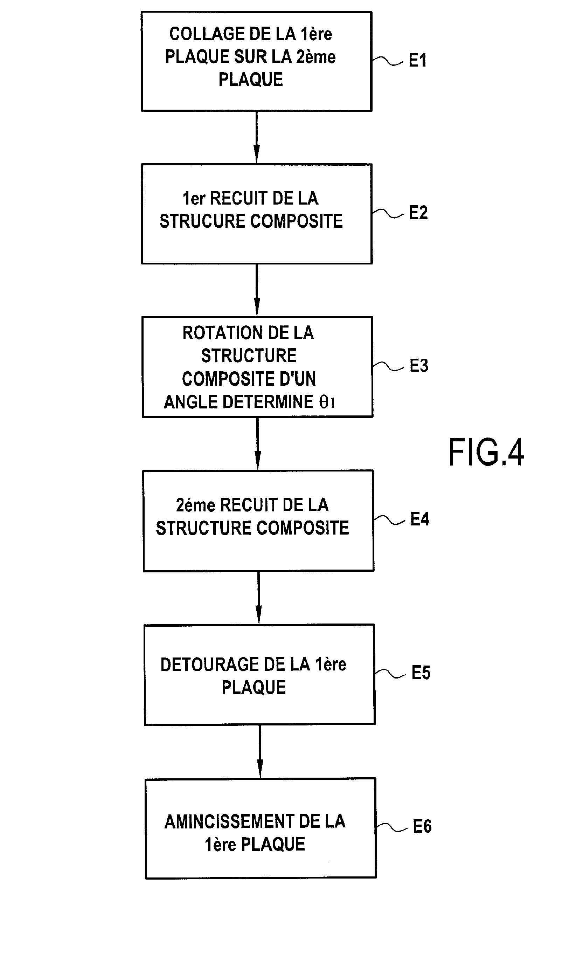

Une mise en oeuvre particulière du procédé de recuit et un premier procédé de réalisation d'une hétérostructure selon l'invention sont à présent décrits en référence aux figures 3A à 3D et 4.

Comme illustré en figure 3A, la première plaque 301, présentant un chanfrein supérieur 304 et un chanfrein inférieur 305, est tout d'abord collée sur une deuxième plaque 302, elle aussi présentant des bords chanfreinés, de manière à former une structure composite 300 (étape E1).

Dans l'exemple décrit ici, les première et deuxième plaques 301 et 302 sont en silicium. Les plaques peuvent cependant être constituées d'autres matériaux.

La première plaque 301 et/ou la seconde plaque 302 peuvent en outre, et préférentiellement, être recouvertes, avant collage, d'une couche d'oxyde (non représentée sur les figures), dans le cadre, par exemple, de la fabrication de structures multicouches de type BSOI.

Dans l'exemple décrit ici, l'assemblage des plaques est réalisé par adhésion moléculaire. Toutefois, comme indiqué précédemment, d'autres types de collage peuvent être envisagés.

La figure 3B représente de manière schématique la structure composite 300, vue du côté de la première plaque 301. Le repère de position « B » représenté au bord de la première plaque 301 correspond, par exemple, à un méplat ou à une mire.

La structure composite 300 est placée sur le support 312. Dans cette première position, les quatre éléments de maintien 312A, 312B, 312C et 312D du support 312 sont ainsi en contact avec respectivement les zones de contact 313A, 313B, 313C et 313D (notées collectivement zones de contact 313) de la deuxième plaque 302. Dans cet exemple, les zones de contact 313 sont réparties le long de la tranche de la deuxième plaque 302.

On peut toutefois envisager que des zones de contact soient situées sur la face arrière de la deuxième plaque 302, par exemple.

La structure composite 300 et son support 312 sont ensuite placés dans un four ou tout autre équipement (non représenté sur les figures) permettant de réaliser un premier recuit de la structure composite 300 en atmosphère oxydante (sèche ou humide) (étape E2).

Dans cet exemple, le premier recuit est réalisé à une température T2 comprise entre 1000°C et 1200°C. Ce premier recuit sert de recuit de stabilisation pour la structure composite 300 puisqu'il permet de renforcer le collage entre la première plaque 301 et la deuxième plaque 302.

Ce premier recuit permet en outre la croissance d'une couche d'oxyde 310 sur la surface extérieure de la structure composite 300, et en particulier, sur la surface extérieure de la deuxième plaque 302. On entend ici par surface extérieure de la deuxième plaque, toute la surface de la deuxième plaque à l'exception de l'interface de collage.

Cette couche d'oxyde a principalement pour but de protéger la surface extérieure de la deuxième plaque 302 des attaques chimiques ultérieures, notamment lors des opérations de détourage chimique et/ou d'amincissement de la première plaque 301.

Dans le cas d'un procédé de réalisation d'une structure multicouche BSOI, la couche d'oxyde 310 ainsi formée peut atteindre par exemple 1 µm d'épaisseur environ.

Une fois la première étape E2 de recuit réalisée, la structure composite 300 est extraite du four. Une couche d'oxyde 310 est alors présente sur toute la surface extérieure de la structure composite 300, à l'exception des zones de contact 314 reparties le long de la tranche de la deuxième plaque 302.

On notera que des zones de la tranche de la première plaque peuvent également être en contact avec le support lors du recuit. Dans ce cas, ces zones sont également dépourvues de couche protectrice d'oxyde à l'issue de la première étape E2 de recuit.

Comme illustré en figure 3C, on réalise ensuite un déplacement de la structure composite 300 sur le support par rotation d'un angle déterminé θ₁ de la structure composite 300 vis-à-vis du support 312 (étape E3). Cette rotation peut être effectuée manuellement ou à l'aide d'un dispositif de positionnement adapté (un aligneur par exemple). La structure composite 300 est ainsi positionnée sur son support 312 dans une deuxième position correspondant à un décalage angulaire d'un angle θ₁ vis-à-vis de la première position (figure 3B).

Une fois la rotation effectuée, les zones de contact 312 de la deuxième plaque 302 ne sont plus en contact avec les éléments de maintien 312.

L'angle de rotation θ₁ est donc choisi en fonction de la géométrie du support 312 utilisé, et plus particulièrement, en fonction de la disposition des éléments de maintien 312A à 312D le long de la tranche de la deuxième plaque 302.

Dans une mise en oeuvre particulière de l'invention, l'angle de rotation θ₁ est compris entre 40 degrés et 90 degrés.

Dans l'exemple décrit ici en figure 3C, la structure composite 300 est tournée d'un angle de rotation θ₁ d'environ 40°.

La structure composite 300 et son support 312 sont ensuite replacés dans un four (ou tout autre équipement adapté) afin de procéder à une deuxième étape de recuit en atmosphère oxydante (sèche ou humide) (étape E4).

Ce deuxième recuit est réalisé à une température T3 comprise, par exemple, entre 900°C et 1200°C.

Cette deuxième étape E4 de recuit permet de faire croître une couche d'oxyde au niveau des anciennes zones de contact 314 (non oxydées) de la deuxième plaque 302. Une telle oxydation est possible car les éléments de maintien du support 312 ne protègent plus les zones de contact 314 de l'atmosphère oxydante.

Le cas échéant, cette deuxième étape de recuit permet également d'oxyder en surface les zones de la première plaque 301 qui étaient en contact avec le support 312 lors de la première étape E2 de recuit.

On notera qu'il n'est pas nécessaire de faire croître une couche d'oxyde aussi épaisse que lors de la première étape de recuit de stabilisation. On peut par exemple configurer la deuxième étape E4 de recuit de manière à former une couche de quelques centaines de nanomètres d'épaisseur sur les anciennes zones de contact 314.

Dans le cadre d'un procédé de réalisation d'une structure multicouches de type BSOI, par exemple, on peut réaliser la deuxième étape E4 de recuit à une température T3 = 950°C de manière à former une couche d'oxyde de 500 nanomètres environ au niveau des anciennes zones de contact 314.

A l'issu de la deuxième étape de recuit E4, une couche d'oxyde est alors présente sur toute la surface extérieure de la structure composite 300, et en particulier sur toute la surface extérieure de la deuxième plaque 302 (la tranche de la deuxième plaque 302 incluse).

Dans l'exemple décrit ici, on procède ensuite au détourage mixte (étape E5) puis à l'amincissement (étape E6) de la première plaque 301 (figure 3D).

L'opération de détourage mixte (étape E5) comprend une première étape de détourage mécanique suivit d'une étape de détourage chimique, comme expliqué en référence aux figures 1D et 1E.

Plus particulièrement, l'étape de détourage mécanique permet d'enlever le bord chanfreiné supérieur 304 de la première plaque 301. Une fois le détourage mécanique réalisé, la portion annulaire restante sur la périphérie de la première plaque 201 n'est plus protégée par de l'oxyde. On peut alors procéder au détourage chimique de cette portion annulaire restante à l'aide d'une solution d'attaque chimique, cette étape permettant d'enlever le bord chanfreiné inférieur 305 de la première plaque 301. Dans l'exemple décrit ici, une solution de TMAH est utilisée pour graver le silicium de la première plaque. D'autres solutions d'attaque chimique peuvent toutefois être envisagées, celles-ci étant choisies notamment en fonction de la composition de la première plaque à détourer. Dans certains cas, on utilise par exemple une solution KOH bien connue de l'homme du métier.

La couche d'oxyde 310 permet de protéger efficacement toute la deuxième plaque 302 de l'attaque chimique mise en oeuvre lors de l'étape de détourage chimique ainsi que des attaques chimiques pouvant être mises en oeuvre dans d'autres étapes technologiques au cours de la fabrication de la structure composite (notamment lors de la fabrication de microcomposants sur la surface exposée de la première plaque amincie).

Une fois l'opération de détourage effectuée, on procède à l'amincissement de la première plaque 301 de manière analogue à l'amincissement de la structure composite 200 (étape E6). On forme ainsi une couche transférée 306 d'une épaisseur déterminée sur la deuxième plaque 302, cette épaisseur pouvant atteindre, par exemple, 10 µm environ (figure 3D). Cette épaisseur est mesurée entre la face supérieure et la face inférieure de la première plaque en dehors du bord chanfreiné.

Dans une variante de ce premier mode de réalisation, aucun traitement n'est réalisé sur la structure 300 entre la première étape de recuit E2 et la deuxième étape de recuit E4. Comme indiqué précédemment, on entend ici par « traitement », une étape technologique quelconque visant à modifier les caractéristiques de la structure. En particulier, aucune étape de gravure chimique, de dépôt de matériaux et/ou de dopage n'est réalisée sur la structure entre les étapes E2 et E4.

Dans cette variante, l'étape de déplacement E3 est la seule opération réalisée sur la structure 300 entre les étapes E2 et E4. Cette variante permet notamment de s'assurer du bon positionnement de la structure 300 lors de la deuxième étape de recuit E4.

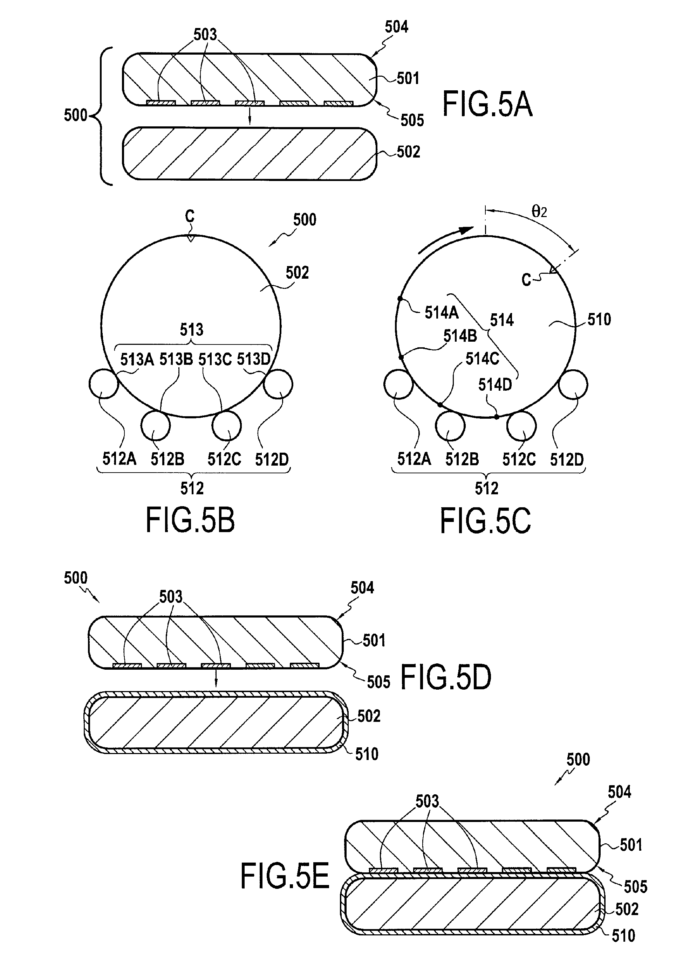

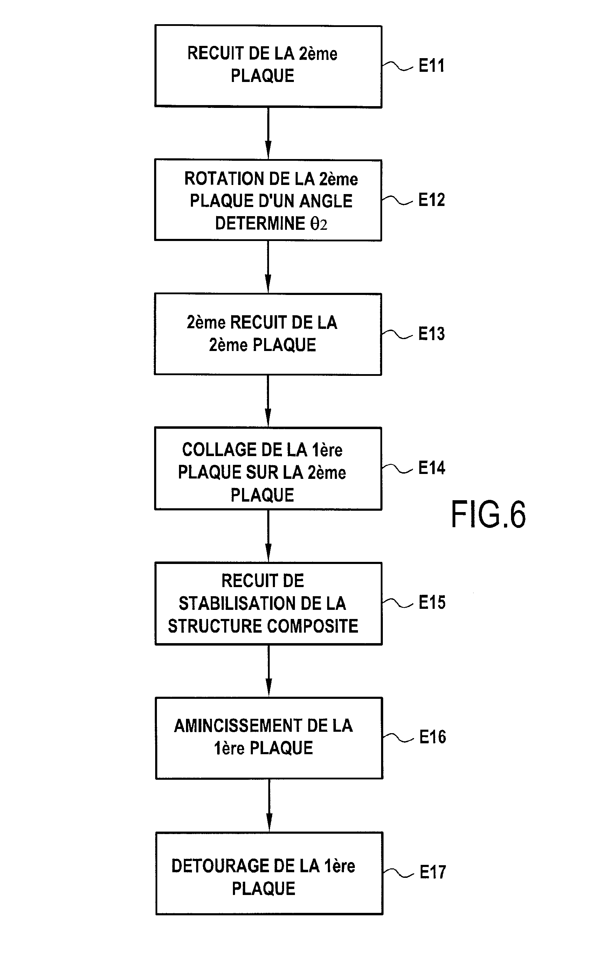

Un autre exemple de procédé de recuit et un second procédé de réalisation d'une hétérostructure selon l'invention sont à présent décrits en référence aux figures 5A à 5E et 6.

La figure 5A représente une première plaque 501 et une deuxième plaque 502. La première plaque 501 diffère de la première plaque 301 décrite en figure 3A en ce qu'elle comporte en outre des microcomposants 503 au niveau de l'une de ses faces. De plus, la première plaque 501 est de préférence une plaque SOI comportant une couche d'isolant enterrée (non représentée sur les figures) correspondant, par exemple, à une couche enterrée d'oxyde de silicium ou de nitrure de silicium, ou alternativement, à un empilement de couches de ces matériaux.

La deuxième plaque comprend un repère de position « C » sur le bord d'une de ses faces.

On entend ici par "microcomposants" tout type d'éléments réalisés avec des matériaux différents de celui de la première plaque. Ces microcomposants correspondent notamment à des éléments formant tout ou partie d'un composant électronique ou d'une pluralité de microcomposants électroniques. Il peut s'agir, par exemple, de composants actifs ou passifs, de simples prises de contact ou d'interconnexions, voire de simples cavités.

La première plaque peut notamment comprendre des microcomposants dans le cas de la technologie d'intégration tridimensionnelle de composants (3D-integration) qui nécessite le transfert d'une ou plusieurs couches de microcomposants sur un support final, ou encore dans le cas de transfert de circuits comme par exemple dans la fabrication d'imageurs éclairés en face arrière. Bien entendu, lorsque de tels microcomposants sont présents, ceux-ci doivent être aptes à supporter le traitement thermique d'oxydation selon (invention. C'est le cas, par exemple, des cavités.

Dans ce second mode de réalisation, le recuit selon le procédé de l'invention est réalisé uniquement sur la deuxième plaque 502.

Les étapes E11, E12 et E13 diffèrent donc des étapes E2, E3 et E4, respectivement, en ce que seule la deuxième plaque 502 subit un premier recuit, suivi d'une rotation et d'un deuxième recuit.

Plus précisément, on dispose la deuxième plaque 502 sur un support (figure 5B) et on réalise une première étape E11 de recuit sous atmosphère oxydante de la deuxième plaque 502, de manière analogue à l'étape E2 décrite précédemment. Ce premier recuit est réalisé à une température T4.

Comme illustré en figure 5C, on réalise ensuite une étape de déplacement par rotation d'un angle θ₂ de la deuxième plaque 502 vis-à-vis de son support (étape E12), de manière analogue à l'étape E3 décrite précédemment.

Une fois la rotation effectuée, on réalise une seconde étape E13 de recuit de la deuxième plaque 502 sous atmosphère oxydante, ce de manière analogue à l'étape E4 décrite précédemment. Ce deuxième recuit est réalisé à une température T5.

A l'issu des étapes E11 à E13, une couche d'oxyde 510 protectrice est présente sur toute la surface de la deuxième plaque 502. Cette couche d'oxyde recouvre en particulier les zones de la deuxième plaque 502 qui étaient en contact avec le support lors de la première étape E11 de recuit (figure 5D).

On procède ensuite au collage de la première plaque 501 sur la deuxième plaque 502 (étape E14), de manière à ce que les microcomposants 503 soient situés à l'interface de collage entre les deux plaques (figure 5E). La plaque 501 peut avoir été pourvue d'une couche de lissage (par exemple en SiO₂ planarisé) afin de fournir une surface de contact plus adapté.

Dans l'exemple décrit ici, l'assemblage est réalisé par la technique d'adhésion moléculaire. Comme expliqué précédemment, d'autres techniques d'assemblage sont toutefois envisageables.

Le deuxième mode de réalisation permet de ne pas faire subir aux microcomposants 503 de la première plaque 501 les premier et deuxième recuits du procédé de l'invention. En effet, les températures élevées qui sont mises en oeuvre lors de ces recuits sont susceptibles d'endommager de manière irréversible les microcomposants 503.

Dans ce second mode de réalisation, il n'existe donc pas de couche d'oxyde protectrice sur la surface extérieure de la première plaque 501. Le premier mode de réalisation diffère également du deuxième mode de réalisation en ce qu'une couche d'oxyde est présente à l'interface de collage entre la première plaque 501 et la deuxième plaque 502.

Une fois le collage réalisé, la structure composite 500 ainsi formée subit un recuit de consolidation qui a pour but de renforcer le collage entre la première plaque 501 et la deuxième plaque 502 (étape E15). Ce recuit est réalisé à une température T6 inférieure aux températures T4 et T5 mises en oeuvre lors des premier et deuxième recuits des étapes E11 et E13. La température T6 est choisie en particulier de manière à ne pas endommager les microcomposants 503 de la première plaque 501. Il peut s'agir d'un recuit entre 400°C et 500°C pendant 30min à 4heures.

Dans l'exemple décrit ici, on réalise ensuite un amincissement (étape E16) comprenant une première étape mécanique (meule) suivi d'un traitement chimique sélectif vis à vis de la couche d'isolant enterrée de la plaque 501. Une étape optionnelle de détourage (E17) de la première plaque 501 peut ensuite être réalisée.

La couche d'oxyde 510 permet de protéger efficacement toute la surface de la deuxième plaque 502 des attaques chimiques mises en oeuvre notamment lors des étapes d'amincissement et éventuellement de détourage.

Par ailleurs, dans certains cas, il peut être nécessaire d'effectuer plus d'une étape de déplacement de la structure composite (rotation) pour permettre l'oxydation de toutes les zones de la deuxième plaque et/ou de la structure qui étaient en contact avec le support lors du premier recuit. Ce cas peut survenir, par exemple, lorsque les zones de contact représentent une portion importante de la tranche de la deuxième plaque et/ou structure.

Dans une variante de ce deuxième mode de réalisation, aucun traitement n'est réalisé sur la deuxième plaque 502 entre la première étape de recuit E11 et la deuxième étape de recuit E13. En particulier, aucune étape de gravure chimique, de dépôt de matériaux et/ou de dopage n'est réalisée sur la deuxième plaque 502 entre les étapes E11 et E13.

Dans cette variante, l'étape de déplacement E12 est la seule opération réalisée sur la deuxième plaque 502 entre les étapes E11 et E13. Cette variante permet notamment de s'assurer du bon positionnement de la deuxième plaque 502 lors de la deuxième étape de recuit E13.

Selon une autre mise en oeuvre du procédé de recuit de l'invention, on réalise tout d'abord une première étape de recuit conformément à l'étape E2 (ou E11).

On réalise ensuite N étapes de rotation (N étant un entier supérieur ou égale à 2), chaque étape de rotation étant suivit d'une étape de recuit analogue à la deuxième étape E4 (ou E13) de recuit décrite précédemment. Chaque deuxième étape de recuit est configurée pour faire croître une couche d'oxyde sur au moins une partie des zones de contact encore non oxydées.

On peut également envisager que l'étape de déplacement du procédé de recuit de l'invention comprenne d'autres types de mouvement de la structure par rapport au support, tels qu'un déplacement par translation par exemple, celui-ci pouvant être combiné à un mouvement par rotation.

## Revendications

1. Procédé de recuit d'une structure comprenant au moins une plaque, ledit procédé de recuit comprenant une première étape de recuit de ladite structure sous atmosphère oxydante de manière à former une couche d'oxyde sur au moins une partie de la surface exposée de ladite structure, ladite structure étant en contact avec un support dans une première position, **caractérisé en ce que** ledit procédé comprend en outre :
- une étape de déplacement de ladite structure oxydée sur le support dans une seconde position dans laquelle la ou les zones de contact entre la structure et le support dans ladite première position sont exposées ; et
- une deuxième étape de recuit de la structure oxydée dans ladite deuxième position sous atmosphère oxydante.

2. Procédé de réalisation selon la revendication 1, dans lequel l'étape de déplacement comprend la rotation de la structure d'un angle déterminé par rapport audit support.

3. Procédé de réalisation selon la revendication 2, dans lequel ledit angle de rotation de la structure lors de l'étape de déplacement est compris entre 40 degrés et 90 degrés.

4. Procédé de réalisation d'une hétérostructure comprenant une étape de collage d'une première plaque sur une deuxième plaque, **caractérisé en ce que** ledit procédé comprend en outre le recuit de ladite hétérostructure selon le procédé de recuit défini dans l'une quelconque des revendications 1 à 3.

5. Procédé de réalisation d'une hétérostructure selon la revendication 4, dans lequel au moins une des étapes suivantes est réalisée après ledit recuit:
- une étape d'amincissement de ladite première plaque, et
- une de chimiques de ladite première plaque.

6. Procédé de réalisation d'une hétérostructure comprenant une étape de collage d'une première plaque sur une deuxième plaque, **caractérisé en ce que** le procédé comprend en outre, avant ladite étape de collage, le recuit de ladite deuxième plaque selon le procédé de recuit défini dans l'une quelconque des revendications 1 à 3.

7. Procédé de réalisation d'une hétérostructure selon la revendication 6, comprenant en outre, avant ladite étape de collage, une étape de formation d'au moins un microcomposant dans la première plaque.

8. Procédé de réalisation d'une hétérostructure selon la revendication 6 ou 7, comprenant en outre une étape de recuit de stabilisation de ladite hétérostructure.

9. Procédé de réalisation d'une hétérostructure selon la revendication 8, dans lequel au moins une des étapes suivantes est réalisée après ledit recuit de stabilisation :
- une étape d'amincissement de ladite première plaque, et
- une étape de détourage chimique de ladite première plaque.
